Europäisches Patentamt

European Patent Office

Office européen des brevets

(11) Publication number: **0 196 863**
**B1**

# (12) EUROPEAN PATENT SPECIFICATION

(45) Date of publication of the patent specification:
24.05.89

(21) Application number: **86302195.2**

(22) Date of filing: **25.03.86**

(51) Int. Cl.⁴: **H 05 K 7/20,** H 01 L 23/46,
H 01 L 23/42

(54) Cooling system for electronic circuit components.

(30) Priority: **28.03.85 JP 64391/85**

(43) Date of publication of application:
**08.10.86 Bulletin 86/41**

(45) Publication of the grant of the patent:
**24.05.89 Bulletin 89/21**

(84) Designated Contracting States:
**CH DE FR GB IT LI NL SE**

(56) References cited:
**EP-A- 0 151 068**
**US-A- 4 155 402**
**US-A- 4 341 432**

(73) Proprietor: **FUJITSU LIMITED, 1015, Kamikodanaka
Nakahara-ku, Kawasaki-shi Kanagawa 211 (JP)**

(72) Inventor: **Kikuchi, Shunichi, 25-8, Hiyoshi 2-chome
Kohoku-ku, Yokohama-shi Kanagawa 223 (JP)**
Inventor: **Matsunaga, Haruyuki, 604-7, Yamagiwa,
Atsugi-shi Kanagawa 243 (JP)**
Inventor: **Katsumi, Hideo, 21-9, Kamimizo 4-chome,
Sagamihara-shi Kanagawa 229 (JP)**
Inventor: **Koji, Katsuyama, 2432-13, Imajuku-cho
Asahi-ku, Yokohama-shi Kanagawa 241 (JP)**

(74) Representative: **Rackham, Stephen Neil et al, GILL
JENNINGS & EVERY 53-64 Chancery Lane, London
WC2A 1HN (GB)**

## Description

This invention relates to a cooling system for electronic circuit components, such as integrated circuit (IC) chips or semiconductor elements, mounted on a printed circuit board, and more particularly, to such a cooling system including a cooling plate in which liquid coolant is circulated.

A cooling plate assembly used for cooling circuit components mounted on a printed circuit board or boards is disclosed in United States Patent No. 4 155 402. In this liquid-cooling plate assembly, a liquid-cooled, cold plate with a compliant mat interface made of a heat-conductive, electrically-insulating compliant structure is arranged in compression contact with diverse circuit components on a printed circuit board so that intimate contact can be achieved with the circuit components, in spite of differences in the relative heights and shapes of the circuit components.

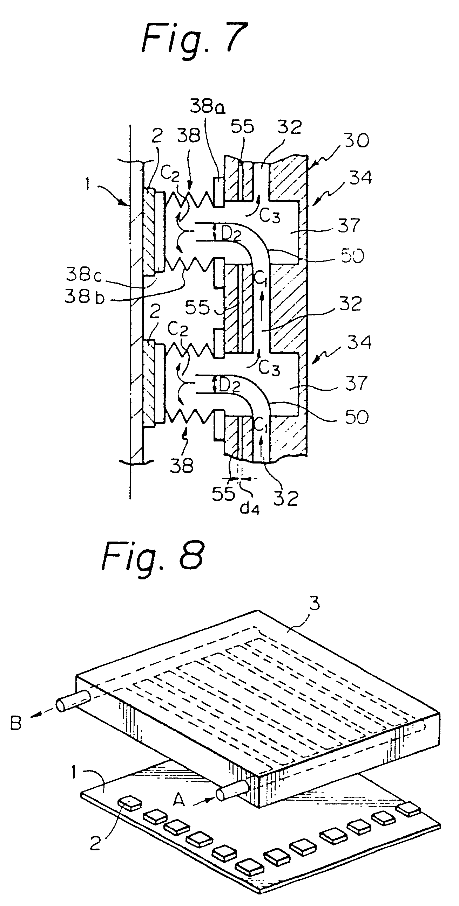

One of the typical known examples of the above-mentioned type of cooling system is shown in Figure 8 of the accompanying drawings, which is an exploded perspective view illustrating a cooling plate arranged adjacent a printed circuit board 1 on which a plurality of electronic components 2 are mounted, so that predetermined cooling points of the plate are in contact with the top surfaces of the electronic components 2. Liquid coolant, such as cooling water, is fed into the cooling plate 3 via an inlet, as shown by an arrow A, and discharged via an outlet, as shown by an arrow B, so that the coolant is circulated through passages in the cooling plate 3 to effect a cooling operation.

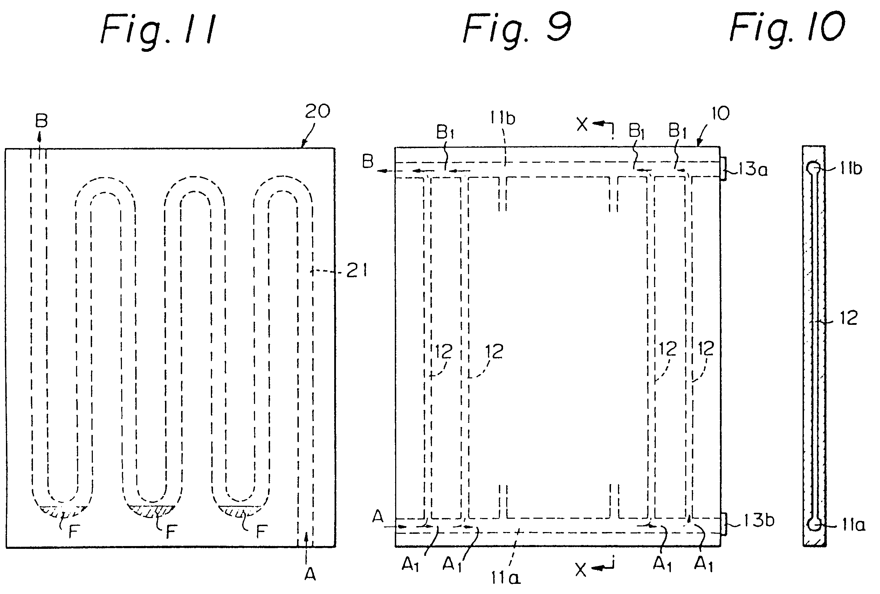

Figure 9 is a plan view illustrating an arrangement of the coolant passage in a conventional cooling plate; and Figure 10 is a cross-sectional view taken along a line X-X in Figure 9. A cooling plate 10 in this example includes lower and upper horizontal main passages 11a and 11b and a plurality of vertical branch passages 12 connected therebetween. These main passages 11a and 11b are closed at their opposite ends by means of closing plugs 13a and 13b, respectively, in the case where the cooling plate 10 is manufactured by a machining process.

Therefore, the coolant supplied, as shown by an arrow A, through the main passage 11a is separated and flows into the respective branch passages 12, as shown by arrows A1. Then the coolant streams are confluent, as shown by arrows B1, and the coolant is discharged from the cooling plate 3, as shown by an arrow B.

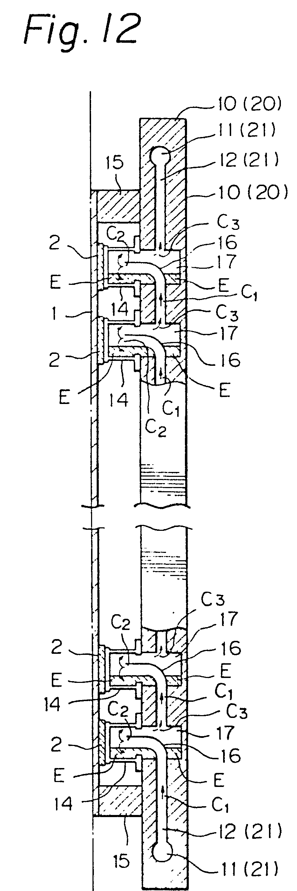

Figure 11 is a plan view illustrating an arrangement of the coolant passage in another example of a conventional cooling plate. In this case, a cooling plate 20 includes a single zig-zag passage 21. The coolant supplied as shown by an arrow A flows through the zig-zag passage 21 and is discharged from the cooling plate 20 as shown by an arrow B.

Figure 12 is a cross-sectional view illustrating heat exchange elements 14 which can be provided in the cooling plate 10 or 20 as mentioned above with reference to Figures 9, 10 and 11. The heat exchanger element 14, made of a resilient or flexible member such as a bellows, is rigidly attached to the cooling plate 10 or 20 on a coolant chamber 17 provided on a way of the branch passage 12 of the cooling plate 10 or the zig-zag passage 21 of the cooling plate 20.

The cooling plate 10 or 20 is vertically arranged adjacent, and parallel to, a printed circuit board 1 and maintained at a predetermined spacing therefrom by means of spacer blocks 15 inserted therebetween, so that the top surfaces of the heat exchanger elements 14 are in resilient contact with the electronic components 2 mounted on the printed circuit board 1.

Therefore, the liquid coolant supplied into the branch passages 11 or the water passage 21, as shown by arrows C1, is injected through nozzles 16 towards the elements 14, as indicated by arrows C2. After the injection, the coolant flows into the next section of the branch passage 11 or the zig-zag passage 21, as shown by arrows C3, and the same operation is repeated. Finally, the coolant flows out of the last cooling chamber 17 into the branch passage 11 of the passage 21.

However, in use of the conventional cooling plate as mentioned above, when draining of the coolant from the cooling plate is necessary, such as when the associated electronic system is taken out of use for maintenance or is transferred to another place, some of the coolant remains in blind portions, as indicated by hatched areas E, of the coolant chambers 17 corresponding to the example shown in Figure 9, or the bottom U-shaped blind portions, as indicated by reference F, of the zig-zag passage 21 in the example shown in Figure 11, even if the liquid coolant was drained from the respective inlet or outlet ports, by feeding high-pressure gas into the opposite port. Therefore, the liquid coolant cannot be completely discharged from the conventional cooling plate 10 or 20. Also, if some of the coolant remains in the cooling plate, damage to the electronic circuit components might occur due to expansion of the coolant, or the cooling system might suffer from corrosion, or might be damaged if the coolant freezes.

Furthermore, if the pressure of the coolant changes rapidly or vibrates, such as water-hammer or ripple, the pressure in the cooling chamber 17 as shown in Figure 12 becomes unstable and dangerous for the circuit components.

An object of the present invention is to provide a cooling system for electronic circuit components, wherein a cooling plate in which liquid coolant is circulated, can be completely emptied of coolant when, for example, the electronic system is taken out of use for maintenance or is transferred to another place.

According to the invention there is provided a cooling system for electronic circuit components mounted on a printed circuit board, the system including a cooling plate arranged substantially parallel to the printed circuit board, the cooling plate having therein one or more coolant passages, thermal contact elements arranged on the cooling plate so as to make resilient contact with surfaces of the electronic circuit components, and means for circulating a liquid coolant through the coolant passage so that the electronic circuit components are cooled, via the thermal contact elements, by the liquid coolant; characterised in that the cooling plate has one or more bypass passages, the cross-sectional area of each of which is smaller than that of the coolant passage, to interconnect predetermined portions of the coolant passage.

In a preferred embodiment the coolant passage is arranged in a zig-zag fashion or is separated into a plurality of branch coolant passages so that the coolant circulates all over the cooling plate, the coolant passage has one or more blind portions when the cooling plate is vertically situated in a predetermined state, and the bypass passages are arranged to interconnect the bottoms of those blind portions and to connect one of the bottoms of the blind portions to another lower level portion of the coolant passage, so that the liquid coolant is discharged under its own gravity via the bypass passage and removed from the cooling plate. Even if the pressure of the coolant changes rapidly, the condition of any cooling point can be kept in balance, as there are two passages (the main passage and the bypass passage) for the cooling point.

By use of the bypass passage arrangement of the invention, which does not appreciably affect the cooling efficiency of the cooling plate, the liquid coolant can be completely discharged from the cooling plate when it is necessary to remove the coolant, such as when the associated electronics system is taken out of operation or is transferred to another place. Therefore, any problems which would otherwise be caused by coolant remaining in the cooling plate, such as freezing of the coolant, corrosion, or the like, are prevented.

Embodiments of the invention will now be described, by way of example, with reference to the accompanying drawings, in which

Figure 1 is a plan view of a cooling system according to the invention;

Figure 2 is a perspective view of the cooling system shown in Figure 1;

Figure 3 is a partial cross-sectional view of a coolant passage of the cooling system shown in Figure 1;

Figure 4 is a perspective view of the cooling system of another embodiment of the invention;

Figure 5 is a partial cross-sectional view of a coolant passage in the embodiment shown in Figure 4;

Figure 6 is a partial cross-sectional view of an alternative coolant passage similar to that of Figure 5;

Figure 7 is a partial cross-sectional view of a further alternative coolant passage similar to that of Figure 5; and

Figures 8, 9, 10, 11 and 12 are views illustrating conventional types of cooling systems, as described above.

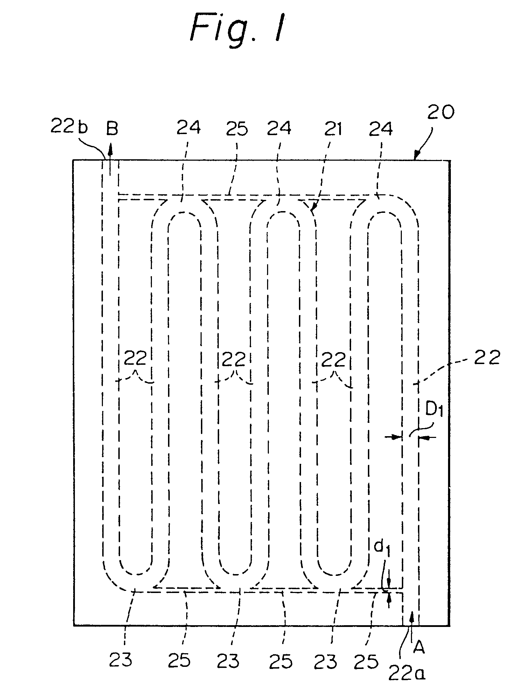

Referring to Figures 1, 2 and 3, a cooling system according to a first embodiment of the present invention is illustrated, in which a cooling plate 20 has a single zig-zag coolant passage 21. That is to say, the coolant passage 21 comprises vertical straight portions 22, and U-shaped bottom and top curved portions 23 and 24. The right-hand vertical straight portion 22 extends to the bottom of the cooling plate 20 to act as a coolant inlet 22a. The left-hand vertical straight portion 22 extends to the top of the cooling plate 20 to act as a coolant outlet 22b. The coolant passage 21 has a substantially uniform circular cross-section, the diameter of which is D1. The U-shaped bottom portions 23 are all located at the same level when this cooling plate 20 is placed vertically in a predetermined position. Alternatively, the cooling plate 20 might be used with its straight portions 22 horizontal, as if the cooling plate 20 in Figure 1 were turned through 90°.

The adjacent bottom portions 23 are interconnected and are connected to the right-hand vertical straight portion 22, in the vicinity of the coolant inlet 22a, by substantially horizontal bypass passages 25. Similarly, the adjacent top portions 24 are interconnected and are connected to the left-hand vertical straight portion 22, in the vicinity of the coolant outlet 22b, by substantially horizontal bypass passages 25. The passages 25 all have a substantially uniform circular cross-section, the diameter d2 of which is 03 to 0.4 times D1, or the cross-sectional area of which is 0.10 to 0.15 times the cross-sectional area of the passage 21. However, as the flowrate through the bypass passages 25 depends on the loss of heat in the main passage 21, these values relative to the values for the main passage have to be determined with careful consideration of the flow characteristics of the cooling plate, especially in the case where the loss of heat in the main passage is small.

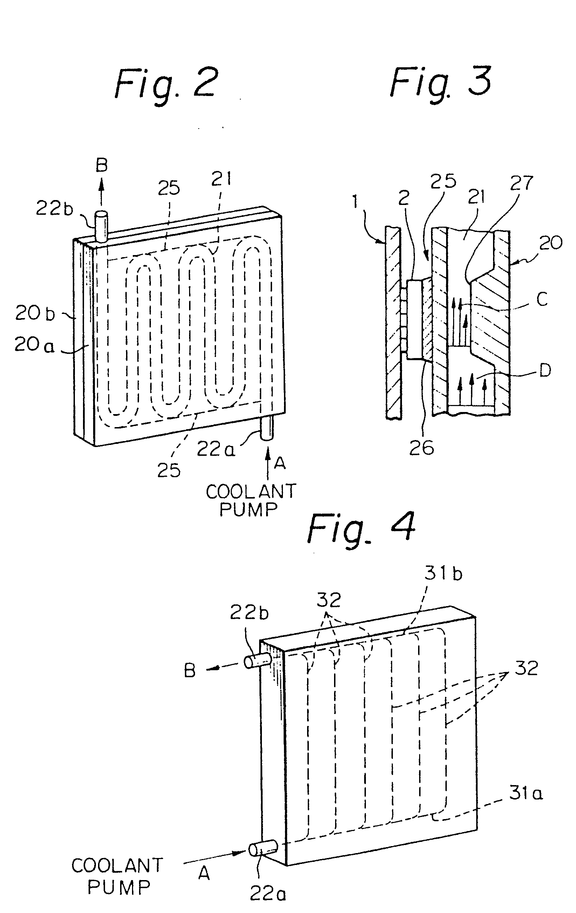

The cooling plate 20 can be made of any suitable material, preferably having a good heat conductivity, such as copper, aluminium or stainless steel, by a process of machining, die-casting, pipe-moulding, or the like. In one method of manufacture, the cooling plate 20 can be made by abutting two plates 20a and 20b, as shown in Figure 2, each having corresponding zig-zag grooves, to form the above-mentioned zig-zag coolant passage 21.

The cooling plate 20 is arranged vertically, adjacent a printed circuit board 1 (Figure 3), in the same manner as mentioned above with reference to Figure 8, so that predetermined cooling points 25 of the cooling plate 20 are in contact with the top surfaces of the electronic components 2 on the printed circuit board 1. At the cooling point 25, a heat transfer member 26, preferably made of a highly heat conductive material such as a compound, insulating sheet or low melting-point solder, can be attached to the surface of the cooling plate 20. It is preferable that the cross-sectional area of the coolant passage 21 be reduced at the cooling point 25 by means of a barrier 27 on the opposite side of the heat transfer piece 26, as seen in Figure 3.

For cooling the electronic components 2 mounted on the printed circuit board 1, a liquid coolant, such as water, fluorocarbon, or liquid metal, is fed as shown by an arrow A into the coolant inlet 22a, which is connected to any suitable coolant source, such as a water pump (not shown). The coolant flows through the zig-zag passage 21 and is discharged, as shown by an arrow B, from the outlet 22b. If there is air in the coolant passage or in a bypass passage 25, the air is discharged toward the outlet 22b and is removed therefrom by the coolant flow. A part of the coolant flows through the bypass passages 26. However, the flow of coolant flowing through the main coolant passage 21 is reduced by only about 10%, since the cross-sectional area of the bypass passages 26 is much smaller than that of the main coolant passage 21. Therefore, the reduction of the cooling efficiency would be almost negligible. On the other hand, the velocity of the coolant is increased as indicated by C at the cooling point 25, due to the reduction of cross-sectional area with respect to that of the main passage 21 as indicated by D. Therefore, the cooling efficiency would be increased by a rapid heat exchange at the cooling point 25. In this case, the above-mentioned diameter D1 should be the diameter of the passage 21 at the point C.

When removing the liquid coolant from the cooling plate 20, the coolant remaining in the zig-zag passage 21 flows through the bypass passages 25 to the coolant inlet 22a. As there are no blind portions, such as those indicated by reference F in Figure 11, no coolant remains in the passage 21, and the coolant is completely discharged from the cooling plate 20. As mentioned above, it is possible to turn the cooling plate 20 shown in Figure 1 by 90°, so that the left or right side becomes the bottom. In this case, the coolant or remaining air can also be completely discharged from the cooling plate 20.

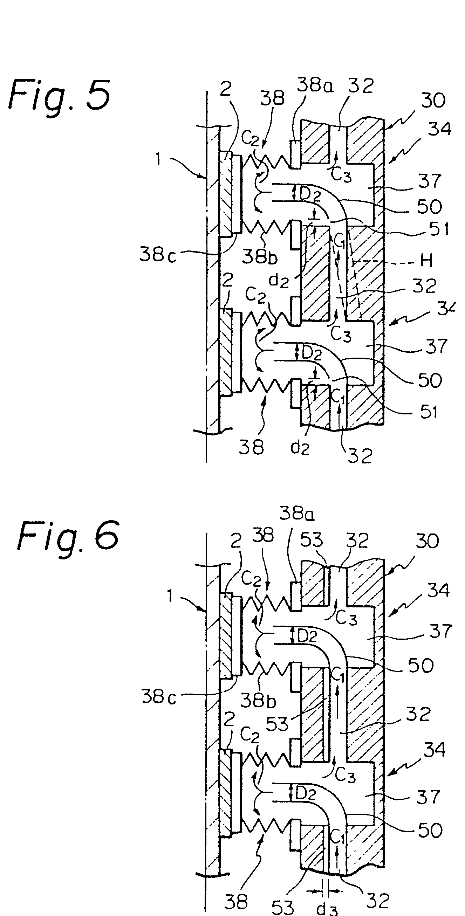

Another embodiment of the invention is shown in Figures 4 to 7, in which a cooling plate 30 is similar to a conventionally known plate 10 shown in Figure 9. That is to say, the cooling plate 30 has lower and upper horizontal main passages 31a and 31b, respectively, and a plurality of vertical branch passages 32 arranged parallel to each other so as to connect the lower horizontal main passage 31a to the upper horizontal main passage 31b. However, the heat exchanging portion in this embodiment is quite different from that of the conventional one mentioned above with reference to Figure 12.

Several alternative forms of the heat exchanging portion are illustrated in Figures 5, 6 and 7, in which a heat exchange unit 34 is provided at each of the cooling points. Each heat exchange unit 34 comprises an open-ended coolant chamber 37 provided in the cooling plate 30 in the run of the branch passage 32, and a hollow resilient member 38 mounted on the open end of the coolant chamber. The member 38 comprises a sealing base 38a sealingly attached to the surface of the cooling plate 30, a bellows 38b, and a heat transfer piece 38c mounted on the top of the bellows 38b so as to be in direct and resilient contact with the surface of a corresponding electronic component 2 mounted on a printed circuit board 1. The hollow resilient member 38 is made of any suitable, good heat conductive, metallic or non-metallic material, such as a plastics material, by a known process. A nozzle pipe 50 protrudes from the branch passage 32 into the coolant chamber 37 and coolant is directed towards the heat transfer piece 38c via the inside of the hollow resilient member 38. The branch passage 32 can be inclined, as shown by a dotted line H in Figure 5, with respect to the surface of the cooling plate 30 so as to direct the liquid coolant easily towards the heat transfer piece 38c.

In the embodiment shown in Figure 5, the pipe 50 has a small opening 51 adjacent a side of the hollow resilient member 38 and at the position of the bottom level of the coolant chamber 37. The diameter d2 of the opening 51 is 0.3 to 0.4 times the inner diameter D2 of the nozzle 50, or the cross-sectional area of the opening is 0.10 to 0.15 times the cross-sectional area of the nozzle, in the same manner as in the above-described embodiment.

In another embodiment shown in Figure 6, the heat exchange unit 34 includes a groove 53 formed in the cooling chamber 30 alongside the branch passage 32, adjacent the hollow resilient member 38, so that the groove 53 connects one coolant chamber 37 to the adjacent coolant chamber 37. The cross-sectional area d3 of the groove 53 is 0.10 to 0.15 times the cross-sectional area D2 of the nozzle 50, in the same manner as above.

In a further embodiment shown in Figure 7, the heat exchange unit 34 comprises a bypass passage 55 formed in the cooling plate 30 and parallel to the branch passage 32 at a side of the hollow resilient member 38 so that the passage 55 connects one coolant chamber 37 to the adjacent coolant chamber 37, in the same manner as in the embodiment shown in Figure 6. Also in the same manner as the above, the diameter d4 of the passage 55 is 0.3 to 0.4 times the inner diameter D2 of the nozzle 50, or the cross-sectional area of the passage 55 is 0.10 to 0.15 times the cross-sectional area of the nozzle.

The cooling plate 30 can be made of the same material and in the same manner as in the above-described embodiment shown in Figures 1 and 2, and can be vertically situated adjacent to a printed circuit board 1 so that the heat transfer piece 38c is in direct and resilient contact with an electronic component 2 mounted on a printed circuit board 1.

For cooling the electronics component 2, a liquid coolant is fed, as shown by an arrow A (Figure 4), via the coolant inlet 22a, into the bot-

tom horizontal main passage 31a. Then, the coolant is separated and flows into the respective branch passages 32, as shown by arrows C1 in Figures 5, 6 or 7. At the cooling point, the coolant is injected through the nozzle pipe 50, as shown by C2, toward the heat transfer piece 38c of the resilient heat exchange unit 38, so that the electronic component 2 which is in contact with the latter is effectively cooled. After the injection, the coolant flows through the coolant chamber 37 into the next section of the branch passage 32, as shown by C3, and the same operation is repeated for the units 34 in turn. Finally, the coolant flows out of the last cooling chamber 37 into the upper main horizontal passage 31b (Figure 4) and is discharged from the coolant outlet 22b, as shown by B. At the cooling point, some of the coolant flows through the opening 51 (Figure 5), the groove 53 (Figure 6), or the bypass passage 55 (Figure 7) directly into the next coolant chamber 37. However, the reduction in the cooling efficiency due to that part of the flow would be almost negligible, since the cross-sectional area for these bypass flows is much smaller than that of the nozzle pipe 50, in the same manner as the above.

As there are no blind portions, (such as that indicated by reference E in the prior device of Figure 12), when the coolant is removed from the cooling plate 30, no coolant remains in any of the chambers 37; it is completely discharged through the opening 51 (Figure 5), the groove 53 (Figure 6), or the bypass passage 55 (Figure 7) directly into the adjacent lower coolant chamber 37. Therefore, no liquid coolant remains in the cooling plate 30. It is sometimes advantageous to moderate the change in the coolant pressure in the chamber 37 by by-passing the coolant, so that the pressure from the heat transfer piece 38c does not affect the electronic component 2.

## Claims

1. A cooling system for electronic circuit components (2) mounted on a printed circuit board (1), the system including a cooling plate (20; 30) to be arranged substantially parallel to the printed circuit board, the cooling plate having therein one or more coolant passages (21; 50), thermal contact elements (25; 38) arranged on the cooling plate so as to make resilient contact with surfaces of the electronic circuit components, and means for circulating liquid coolant through the coolant passage, so that the electronic circuit components are cooled, via the thermal contact elements, by the liquid coolant; characterised in that the cooling plate has one or more bypass passages (25; 51; 53; 55), the cross-sectional area of each of which is smaller than that of the coolant passage, to interconnect predetermined portions of the coolant passage.

2. A cooling system according to claim 1, characterised in that the coolant passage (21) is arranged in a zig-zag fashion or is separated into a plurality of branch coolant passages so that the coolant circulates through the cooling plate, the coolant passage having one or more blind portions when the cooling plate is situated vertically in a predetermined state, and the bypass passage (25) is arranged so as to interconnect the bottoms of the blind portions and to connect one of the bottoms of the blind portions to another lower level portion of the coolant passage, so that the liquid coolant can be discharged under its own gravity via the bypass passage and hereby removed from the cooling plate.

3. A cooling system according to claim 1 or claim 2, characterised in that the coolant passage (21) is arranged in a zig-zag fashion and has straight portions (22) arranged parallel to each other and U-shaped first end portions (23) and second end portions (24) connecting the straight portions in turn, at opposite ends thereof, alternately; and the bypass passages (25) are arranged so as to interconnect the first end portions and to interconnect the second end portions, and to connect one of the first end portions to one of the straight portions in the vicinity of a coolant inlet (22a) and to connect one of the second end portions to one of the straight portions in the vicinity of a coolant outlet (22b).

4. A cooling system according to claim 3, characterised in that, in use, the straight portions (22) are arranged substantially vertically or substantially horizontally.

5. A cooling system according to any preceding claim, characterised in that the coolant passage (20) has a reduced cross-sectional area (C) at a cooling point, at which a contact element (26) is arranged on the surface of the cooling plate.

6. A cooling system according to claim 1, characterised in that the coolant passage comprises a lower horizontal main passage (31a) connected to a coolant inlet (22a) and an upper horizontal main passage (31b) connected to a coolant outlet (22b), the main passages being arranged substantially parallel to each other; and a plurality of vertical branch passages (32) arranged parallel to each other and between the lower and upper main passages.

7. A cooling system according to any preceding claim, characterised in that the cooling plate (30) has a plurality of coolant chambers (37) at respective cooling points, each of the coolant chambers comprising a hollow resilient member (38b) which defines therein a part of the coolant chamber and a contact member (38b) which closes the resilient member; a nozzle pipe (50) protruding from the coolant passage into the coolant chamber so that the coolant is injected towards a portion of the hollow resilient member adjacent the electronic component (2) to be cooled.

8. A cooling system according to claim 7, characterised in that each bypass passage comprises at least one opening (51) provided in the pipe nozzle at a bottom level of each coolant chamber (38).

9. A cooling system according to claim 7, characterised in that the bypass passage comprises at least one groove (53) provided in the cooling plate (30), at each cooling point, the groove extending along the coolant passage (32) to the adjacent cooling chamber (37).

10. A cooling system according to claim 7, characterised in that the bypass passage (55) is arranged parallel to the coolant passage (32), at each cooling point, and extends to the adjacent cooling chamber (37).

11. A cooling system according to any preceding claim, characterised in that the cross-sectional area of the bypass passage is 0.10 to 0.15 times that of the coolant passage.

## Patentansprüche

1. Kühlsystem für elektronische Schaltungskomponenten (2), die auf einer gedruckten Schaltungskarte (1) montiert sind, welches System eine Kühlplatte (20; 30) enthält, die im wesentlichen parallel zu der gedruckten Schaltungskarte anzuordnen ist, welche Kühlplatte innen eine oder mehrere Kühlpassagen (21; 50), thermische Kontaktelemente (38), die auf der Kühlplatte so angeordnet sind, dass sie einen elastischen Kontakt mit den Oberflächen der elektronischen Schaltungskomponenten bilden, und Einrichtungen zum Zirkulieren flüssigen Kühlmittels durch die Kühlpassage hat, so dass die elektronischen Schaltungskomponenten, über die thermischen Kontaktelemente, durch das flüssige Kühlmittel gekühlt werden; dadurch gekennzeichnet, dass die Kühlplatte eine oder mehrere Beipass-Passagen (25; 51; 53; 55) hat, deren Querschnittsbereich jeweils kleiner als derjenige der Kühlpassage ist, um vorbestimmte Abschnitte der Kühlpassage miteinander zu verbinden.

2. Kühlsystem nach Anspruch 1, dadurch gekennzeichnet, dass die Kühlpassage (21) in einer Zickzack-Art angeordnet oder in eine Vielzahl von Zweigkühlpassagen unterteilt ist, so dass das Kühlmittel durch die Kühlplatte zirkuliert, wobei die Kühlpassage ein oder mehrere blinde Abschnitte hat, wenn die Kühlplatte vertikal in einem vorbestimmten Zustand angeordnet ist, und die Beipass-Passage (25) so angeordnet ist, dass sie die Böden der blinden Abschnitte miteinander verbindet und einen der Böden der blinden Abschnitte mit einem anderen Abschnitt tiefen Pegels der Kühlmittelpassage verbindet, so dass das flüssige Kühlmittel aufgrund seiner eigenen Schwerkraft über die Beipass-Passage entladen und hierdurch aus der Kühlplatte entfernt wird.

3. Kühlsystem nach Anspruch 1 oder 2, dadurch gekennzeichnet, dass die Kühlpassage (21) in Zickzack-Art angeordnet ist und gradlinige Abschnitte (22) aufweist, die parallel zueinander angeordnet sind, und U-förmige erste Endabschnitte (23) und zweite Endabschnitte (24), welche die gradlinigen Abschnitte der Reihe nach an entgegengesetzten Enden davon, alternativ, miteinander verbinden; und die Beipass-Passagen (25) so angeordnet sind, dass sie die ersten Endabschnitte mit den zweiten Endabschnitten verbinden, und um einen der ersten Endabschnitte mit einem der gradlinigen Abschnitte in der Nähe des Kühlmitteleinlasses (22a) zu verbinden und einen der zweiten Endabschnitte mit einem der gradlinigen Abschnitte in der Nachbarschaft des Kühlmittelauslasses (22b) zu verbinden.

4. Kühlsystem nach Anspruch 3, dadurch gekennzeichnet, dass, in Betrieb, die gradlinigen Abschnitte (22) im wesentlichen senkrecht oder im wesentlichen horizontal angeordnet sind.

5. Kühlsystem nach einem der vorhergehenden Ansprüche, dadurch gekennzeichnet, dass die Kühlmittelpassage (20) einen Bereich (C) mit reduziertem Querschnitt bei einem Kühlpunkt hat, bei dem ein Kontaktelement (26) auf der Oberfläche der Kühlplatte angeordnet ist.

6. Kühlsystem nach Anspruch 1, dadurch gekennzeichnet, dass die Kühlmittelpassage eine untere horizontale Hauptpassage (31a) umfasst, die mit einem Kühlmitteleinlass (22a) verbunden ist, und eine obere horizontale Hauptpassage (31b), die mit einem Kühlmittelauslass (22b) verbunden ist, wobei die Hauptpassagen im wesentlichen parallel zueinander angeordnet sind; und eine Vielzahl von vertikalen Zweigpassagen (32), die parallel zueinander und zwischen der unteren und oberen Hauptpassage angeordnet sind.

7. Kühlmittelsystem nach einem der vorhergehenden Ansprüche, dadurch gekennzeichnet, dass die Kühlplatte (30) eine Vielzahl von Kühlkammern (37) an entsprechenden Kühlpunkten hat, von denen jede Kühlkammer ein hohles elastisches Teil (38b) umfasst, welches darin einen Teil einer Kühlmittelkammer begrenzt, und ein Kontaktteil (38c), welches das elastische Teil schliesst; ein Düsenrohr (50), welches von der Kühlmittelpassage in die Kühlkammer vorsteht, so dass das Kühlmittel zu einem Abschnitt des hohlen elastischen Teils neben der elektronischen Komponente (2), die gekühlt werden soll, injiziert wird.

8. Kühlsystem nach Anspruch 7, dadurch gekennzeichnet, dass jede Beipass-Passage wenigstens eine Öffnung (51) umfasst, die in der Rohrdüse an einem Bodenpegel von jeder Kühlmittelkammer (38) vorgesehen ist.

9. Kühlsystem nach Anspruch 7, dadurch gekennzeichnet, dass die Beipass-Passage wenigstens eine Nut (53) umfasst, die in der Kühlplatte (30) bei jedem Kühlpunkt vorgesehen ist, welche Nut sich längs der Kühlpassage (32) zu der benachbarten Kühlkammer (37) erstreckt.

10. Kühlsystem nach Anspruch 7, dadurch gekennzeichnet, dass die Beipass-Passage (55) parallel zu der Kühlmittelpassage (32) angeordnet ist, an jedem Kühlpunkt, und sich zu der angrenzenden Kühlkammer (37) erstreckt.

11. Kühlsystem nach einem der vorhergehenden Ansprüche, dadurch gekennzeichnet, dass der Querschnittsbereich der Beipass-Passage 0,10 bis 0,15 Mal so gross wie derjenige der Kühlmittelpassage ist.

## Revendications

1. Ensemble de refroidissement pour composants (2) d'un circuit électronique, montés sur une carte (1) de circuit imprimé, l'ensemble comprenant une plaque de refroidissement (20; 30) destinée à être placée afin qu'elle soit sensiblement parallèle à la carte de circuit imprimé, la plaque de refroidissement ayant à l'intérieur un ou plusieurs passages (21; 50) de circulation d'un fluide de refroidissement, des éléments de contact thermique (38) placés sur la plaque de refroidissement afin qu'ils soient en contact élastique avec des surfaces des composants du circuit électronique, et un dispositif destiné à faire circuler le liquide de refroidissement dans le passage afin que les composants du circuit électronique soient refroidis, par l'intermédiaire des éléments de contact thermique, par le liquide de refroidissement, caractérisé en ce que la plaque de refroidissement comporte un ou plusieurs passages de dérivation (25; 51; 53; 55), la section de chacun de ces passages étant inférieure à celle du passage du fluide de refroidissement, ces passages étant destinés à interconnecter les parties prédéterminées du passage du fluide de refroidissement.

2. Ensemble de refroidissement selon la revendication 1, caractérisé en ce que le passage (21) de fluide de refroidissement est disposé sous forme sinueuse ou est séparé en plusieurs passages de fluide de refroidissement en dérivation afin que le fluide de refroidissement circule dans la plaque, le passage de fluide de refroidissement ayant une ou plusieurs parties borgnes lorsque la plaque est disposée verticalement dans un état prédéterminé, et le passage de dérivation (25) est disposé de manière qu'il relie les parties inférieures des parties borgnes et qu'il relie l'une des parties inférieures des parties borgnes à une autre partie de niveau inférieur du passage de fluide de refroidissement si bien que le liquide de refroidissement peut être évacué sous son propre poids par l'intermédiaire du passage de dérivation et est ainsi retiré de la plaque de refroidissement.

3. Ensemble de refroidissement selon la revendication 1 ou 2, caractérisé en ce que le passage (21) de fluide de refroidissement est disposé sous forme sinueuse et a des parties rectilignes (22) disposées parallèlement les unes aux autres, des premières parties d'extrémité (23) en U et des secondes parties d'extrémité (24) en U reliant tour à tour les parties rectilignes, à leurs extrémités opposées et en alternance, et les passages de dérivation (25) sont disposés de manière qu'ils relient les premières parties d'extrémité et qu'ils relient les secondes parties d'extrémité, et qu'ils relient l'une des premières parties d'extrémité à l'une des parties rectilignes à proximité d'une entrée (22a) de fluide de refroidissement et qu'ils relient l'une des secondes parties d'extrémité à l'une des parties rectilignes à proximité d'une sortie de fluide de refroidissement (22b).

4. Ensemble de refroidissement selon la revendication 3, caractérisé en ce que, pendant l'utilisation, les parties rectilignes (22) sont disposées en direction sensiblement verticale ou sensiblement horizontale.

5. Ensemble de refroidissement selon l'une quelconque des revendications précédentes, caractérisé en ce que le passage (20) de fluide de refroidissement a une section réduite (C) à un emplacement de refroidissement auquel un élément de contact (26) est disposé à la surface de la plaque de refroidissement.

6. Ensemble de refroidissement selon la revendication 1, caractérisé en ce que le passage de fluide de refroidissement comporte un passage principal horizontal inférieur (31a) connecté à une entrée (22a) de fluide de refroidissement et un passage principal horizontal supérieur (31b) connecté à une sortie de fluide de refroidissement (22b), les passages principaux étant disposés afin qu'ils soient pratiquement parallèles les uns aux autres, et plusieurs passages verticaux de dérivation (32) disposés parallèlement les uns aux autres et entre les passages principaux inférieur et supérieur.

7. Ensemble de refroidissement selon l'une quelconque des revendications précédentes, caractérisé en ce que la plaque de refroidissement (30) a plusieurs chambres (37) de fluide de refroidissement à des emplacements respectifs de refroidissement, chacune des chambres de fluide de refroidissement comportant un organe élastique creux (38b) qui délimite à l'intérieur une partie de la chambre de fluide de refroidissement et un organe de contact (38c) qui ferme l'organe élastique, une tuyauterie (50) à buse dépassant du passage de fluide de refroidissement dans la chambre de fluide de refroidissement afin que le fluide de refroidissement soit injecté vers une partie de l'organe élastique creux qui est adjacente au composant électronique (2) qui doit être refroidi.

8. Ensemble de refroidissement selon la revendication 7, caractérisé en ce que chaque passage de dérivation comporte au moins une ouverture (51) formée dans la buse de la tuyauterie au niveau inférieur de chaque chambre (38) de fluide de refroidissement.

9. Ensemble de refroidissement selon la revendication 7, caractérisé en ce que le passage de dérivation comporte au moins une gorge (53) formée dans la plaque de refroidissement (30), à chaque emplacement de refroidissement, la gorge étant disposée le long du passage (32) de fluide de refroidissement jusqu'à la chambre adjacente (37) de refroidissement.

10. Ensemble de refroidissement selon la revendication 7, caractérisé en ce que le passage de dérivation (55) est disposé parallèlement au passage (32) de fluide de refroidissement, à chaque emplacement de refroidissement, et rejoint la chambre adjacente (37).

11. Ensemble de refroidissement selon l'une quelconque des revendications précédentes, caractérisé en ce que la section du passage de dérivation est comprise entre 0,10 et 0,15 fois celle du passage de fluide de refroidissement.

# Fig. I

Fig. 2

Fig. 3

Fig. 4

*Fig. 5*

*Fig. 6*

## Fig. 7

## Fig. 8

Fig. 9

Fig. 10

Fig. 11

17

# Fig. 12

19